# EUROPEAN PATENT SPECIFICATION

(11) **EP 4 391 047 B1**
(45) Date of publication and mention of the grant of the patent: **08.10.2025**
(21) Application number: 22214723.3
(22) Date of filing: 19.12.2022
(51) Int. Cl.: H01L 23/522, H10D 1/68, H01L 21/768

(54) **A MIMCAP ASSEMBLY AND METHOD OF PRODUCING THEREOF**
MIMCAP-ANORDNUNG UND VERFAHREN ZU DESSEN HERSTELLUNG
ENSEMBLE MIMCAP ET SON PROCÉDÉ DE PRODUCTION

(43) Date of publication of application: 26.06.2024
(73) Proprietor: IMEC VZW, 3001 Leuven (BE)
(72) Inventor: Eric, Beyne, 3001 Heverlee (BE); Nolmans, Philip, 3471 Hoeleden (BE); Miyaguchi, Kenichi, 3001 Heverlee (BE)
(74) Representative: Patent Department IMEC

(56) References cited:
- US-A1- 2015 115 401
- US-A1- 2017 104 057
- US-A1- 2020 176 552

## Description

### Field of the Invention

The present invention is related to semiconductor processing, in particular to the integration of large-area capacitors in a multilayer interconnect structure.

### State of the art.

Multilayer interconnect structures as referred to above consist of multiple layers of nanometre-to-micrometre-sized (usually metal) conductor lines interconnected by vertical via connections and embedded in a dielectric material. The main application for this type of structure is the so-called back end of line (BEOL) portion of integrated circuit chips. The BEOL portion connects the active devices such as transistors and diodes which have been fabricated on the front side of the semiconductor substrate portion of the chip, to contact terminals on the top side of the chip. Today, BEOL type structures are also found on the back side of the chip, for example in the form of a back side power delivery network, connected to the active devices of the chip by through-semiconductor via (TSV) connections. BEOL type structures are also found on larger components, such as interposer chips.

It is known to incorporate large area capacitors in a BEOL type interconnect structure, mainly for use in the power supply regulation of the chip, for example in charge pumps or other types of integrated voltage regulators. A commonly used term for this type of capacitor is the MIMcap (metal-insulator-metal capacitor), referring to the fact that it is built from two layers of electrically conductive material separated by a thin dielectric. This term will be used also in the present description, although it is never intended to limit the scope of the invention to the use of metals for the conductive plates of the capacitor.

The MIMcap's capacitance value is defined by its effective surface area and the ratio of the dielectric constant to the thickness of the dielectric. By choosing materials with a high dielectric constant and using very thin layers, high capacitance values can be obtained. However, this will decrease the capacitor quality as it will inevitably cause an increase in leakage current or a decrease in breakdown voltage and reliability. Therefore, the main factor for increasing capacitance values is the increase in the effective surface area. This is however difficult to achieve using planar MIMcap designs, due to the lack of available surface area on the chips.

Larger surface areas are obtainable by non-planar MIMcaps. One recent design of this type is disclosed in the document entitled '91.5%-Efficiency Fully Integrated Voltage Regulator with 86fF/µm2-High-Density 2.5D MIM Capacitor', H. Lin et al, 2021 Symposium on VLSI Technology, pp. 1-2. This MIMcap structure is obtained by producing a regular array of dielectric pillars on a conductive bottom layer, and depositing the layers of the MIMcap conformally on the topography defined by the pillars, followed by filling the areas between the pillars by a layer of copper, planarizing the copper and the layers of the MIMcap and providing contacts to the top and bottom plates of the MIMcap. The term '2.5D' has been introduced to refer to the pillars, and to distinguish the structure from what is commonly referred to as 3D MIMcaps, which involve trench-type structures extending into the silicon substrate. The problem with the latter is that they are likely to cause unwanted coupling effects between the MIMcap and the substrate.

The 2.5D structure realizes a considerable increase in the surface area compared to planar MIMcaps, while also realizing an effective decoupling of the capacitor from the silicon substrate. An additional increase in the capacitance of the 2.5D design could be obtained by realizing a larger aspect ratio of the dielectric pillars, but this represents a considerable technical challenge.

Further prior art is known from US 2017/104057, US 2015/115401 and US 2020/176552.

### Summary of the invention

The invention aims to provide an alternative solution to the problem of applying the '2.5D' design referred to in the previous paragraph to obtain a MIMcap structure having an increased capacitance. This aim is achieved by the capacitor assembly as disclosed in the appended claims. The invention is in particular related to semiconductor components such as integrated circuit chips or interposer chips, comprising a multilayer structure such as a back end of line portion, with a plurality of MIM capacitors integrated between two levels of the multilayer structure. The capacitors are realized as an assembly of capacitors, in the form of a stack of at least three electrically conductive layers, separated by dielectric layers, and formed conformally on a topography defined by a plurality of dielectric pillars distributed on a bottom conductive plate formed on a first level of the multilayer interconnect structure. By realizing a height difference between different pillars or different groups of pillars, the intermediate conductive layers of the stack become available for contacting said layers by via connections of the next level of the interconnect structure. In this way, a circuit comprising multiple parallel capacitors can be realized, which significantly increases the capacitance of the overall assembly. The method of the invention includes the deposition of a thick dielectric layer and one or more additional dielectric layers thereon. Openings are produced in the additional layers before patterning the layers to form the pillars, so that the thicknesses of the additional layers determine the height differences between the pillars. By carefully controlling said thicknesses in relation to the thicknesses of the layers of the capacitor assembly, contacting of the intermediate conductive layers of the stack is enabled.

The invention is related in particular to a semiconductor component comprising a multilayer interconnect structure, said structure comprising multiple levels of electrical conductor lines and via connections embedded in layers of dielectric material, the interconnect structure comprising :
- an electrically conductive bottom plate, on and in electrically conductive contact with one or more conductor lines of a first level of the interconnect structure,
- a dielectric layer that is part of a second level of the interconnect structure lying directly above the first level, wherein said dielectric layer:
   o is lying directly on the bottom plate,
   o comprises a cavity through its full thickness and lying within the boundaries of the bottom plate,
- a plurality of pillars of dielectric material distributed on the bottom plate,

characterized in that the interconnect structure further comprises :
   - a stack of layers comprising at least three electrically conductive layers, including a bottom layer, a top layer and at least one intermediate layer, wherein the stack further comprises dielectric layers which separate the conductive layers from each other, and wherein the layers of the stack follow the topography defined by the bottom plate, the sidewalls of the pillars and the sidewalls of the cavity,
   - a continuous layer of electrically conductive material that fills the remaining volume of the cavity, and that is in direct contact with the top conductive layer of the stack, wherein the pillars or several subgroups of pillars have different heights, and wherein the height differences are configured so that:
      o each intermediate conductive layer of the stack and all layers of the stack lying beneath said intermediate layer additionally follow the topography defined by the top surface of one or more pillars,
      o in separate areas above said top surfaces of said one or more pillars, the upper surface of each intermediate layer is coplanar with the upper surface of the continuous conductive layer,
   - a plurality of via connections of the second level of the interconnect structure, including :
      o one or more via connections which are in direct contact with the upper surface of the continuous conductive layer,
      o one or more via connections which are in direct contact with said intermediate conductive layers of the stack, in said one or more separate areas,
      o one or more via connections which are in direct or indirect contact with the bottom conductive layer of the stack,
so that the stack of layers forms an assembly of capacitors, each capacitor comprising two electrodes and a dielectric, formed by two adjacent conductive layers of the stack and their separating dielectric layer, wherein the bottom electrode of the capacitor assembly, the top electrode of the capacitor assembly and each intermediate electrode can be contacted through said plurality of via connections of the second level of the interconnect structure.

According to an embodiment, the component comprises one or more pillars whose height is configured so that the bottom conductive layer of the stack follows the topography defined by the upper surface of said pillars, and :
- said bottom conductive layer is coplanar with the continuous conductive layer in respective additional separate areas lying above said one or more pillars, and
- one or more via connections of the second level are in direct contact with said bottom conductive layer in said additional areas.

According to an embodiment, the second level comprises one or more via connections which are in indirect contact with the bottom conductive layer of the stack, and said indirect contact is realized by the following :
- said one or more via connections pass through said dielectric layer
- said one or more via connections are in electrical contact with a conductor line of the first level, and
- said conductor line is in electrical contact with the bottom plate.

According to an embodiment, said component is a semiconductor chip and the interconnect structure is a BEOL portion formed on the front side of the chip.

According to an embodiment, said component is a semiconductor chip and the interconnect structure is a power delivery network formed on the back side of the chip.

According to an embodiment, said stack of capacitors comprises at least two capacitors coupled in parallel.

The invention is also related to a method for producing a stack of capacitors incorporated in an interconnect structure of a semiconductor component, said structure comprising multiple levels of electrical conductor lines and via connections embedded in layers of dielectric material, the method comprising the steps of :
- producing a level Mₙ of the interconnect structure, with n lower than the total number of levels, thereby obtaining a planarized surface comprising conductor lines of level Mₙ embedded in and coplanar with a dielectric layer,
- producing on said planarized surface and in direct contact with one or more of said conductor lines, an electrically conductive bottom plate,
- producing a first dielectric layer on the bottom plate and on the rest of the planarized surface,
- producing at least one additional dielectric layer on the first dielectric layer, the additional layer or layers being thin in comparison with the first layer,
- in a region above the bottom plate, producing one or more first openings in the upper additional layer by locally removing material of said upper layer, without substantially removing any material of the layer lying directly under said upper layer,
- if more than one additional layer is present, producing in said region one or more second openings separate from the first openings, by locally removing material of the upper layer and the layer lying under said upper layer, without substantially removing any material of the next layer,
- if more than two additional layers are present, repeating the previous step until reaching the first dielectric layer,
- by lithography and etching, removing the material of the first and additional dielectric layers in an area having a circumference that surrounds all the openings, except in predefined portions of said openings, thereby creating a cavity that lies within the outer boundaries of the bottom plate, with pillars of dielectric material remaining on the bottom of the cavity, the pillars having different heights in accordance with the number of additional layers produced on the first dielectric layer,
- producing a stack of layers on the topography defined by the cavity and the pillars, said stack comprising at least three electrically conductive layers, including a bottom layer, a top layer and at least one intermediate layer, wherein the stack further comprises dielectric layers which separate the conductive layers from each other, and wherein the layers of the stack are conformal layers, i.e. layers which follow the topography defined by the cavity and the pillars,
- filling the remaining volume of the cavity with an electrically conductive material, wherein said electrically conductive material is in direct contact with said top conductive layer,
- planarizing the electrically conductive material and the stack to the level of the top additional dielectric layer or slightly beyond said level, to thereby create a planarized continuous conductive layer, wherein the thicknesses of the one or more additional dielectric layers are configured in relation to the thicknesses of the layers of the stack, so that each of the intermediate conductive layers of the stack is planarized to the same level as the continuous conductive layer, in respective separate areas above a plurality of pillars which are lower than the level of the top additional layer,
- producing interconnect vias of the subsequent level Mₙ₊₁ of the interconnect structure, including :
   ∘ one or more via connections which are in direct contact with the upper surface of the continuous conductive layer,
   ∘ one or more via connections which are in direct contact with said intermediate conductive layers of the stack, in said one or more separate areas,
   ∘ one or more via connections which are in direct or indirect contact with the bottom conductive layer of the stack.

### Brief description of the figures

The figures are conceptual illustrations of the capacitor configurations and methods of the invention. They are not intended to represent real-life semiconductor components.
Figures 1a to 1c illustrate a MIMcap in accordance with the prior art.
Figures 2a to 2c illustrate a MIMIMcap configuration in accordance with a first embodiment of the invention.
Figures 3a to 3i show key steps of the method for producing the configuration shown in Figures 2a to 2c.
Figures 4a to 4c illustrate a MIMIMcap configuration in accordance with a second embodiment.
Figures 5a to 5e illustrate key steps of the method for producing the configuration shown in Figures 4a to 4c.
Figures 6aand 6b and Figures 7a and 7b illustrate configurations comprising three MIM capacitors.

### Detailed description of the invention

In the following detailed description, all cited materials and dimensions are merely stated by way of example and are not limiting the scope of the invention, which is defined only by the appended claims.

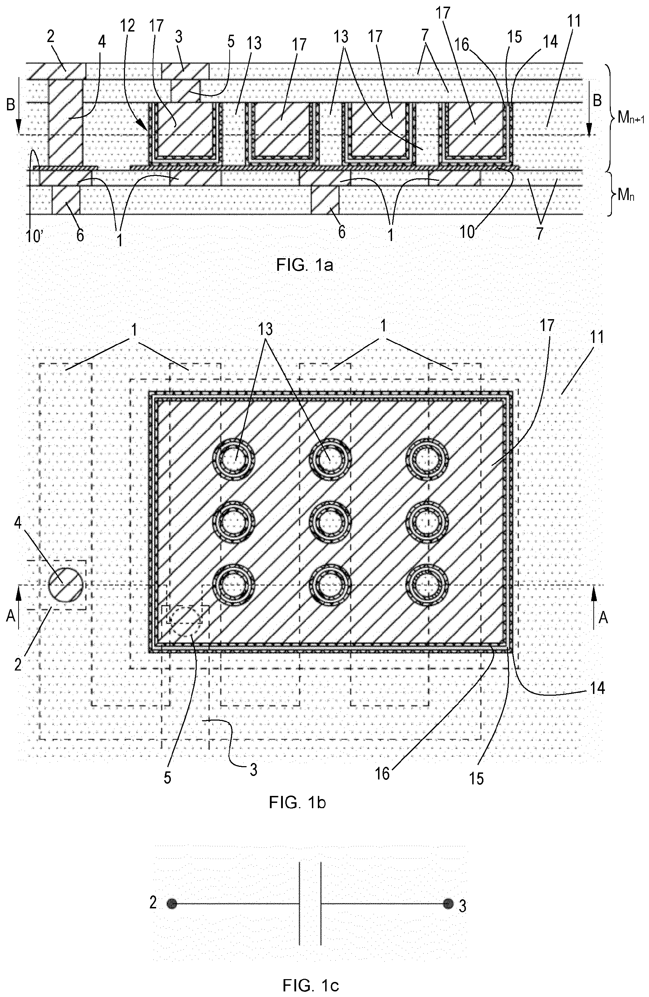

A MIMcap in accordance with the disclosure by H. Lin et al cited in the introduction will be described first, followed by embodiments of the invention, so that the differences with the prior art design are clearly understood. The prior art MIMcap is shown in the two section views of Figures 1a and 1b. The MIMcap is integrated between two adjacent levels Mₙ and Mₙ₊₁ of a multilevel interconnect structure of a semiconductor component, which may for example be the BEOL portion on the front side of an integrated circuit chip or a power delivery network on the back side of the chip. Each level comprises horizontal conductor lines 1,2,3 and vertical via connections 4,5,6. The via connections interconnect the metal lines of the adjacent levels. The levels are numbered generically as n and n+1, wherein n can be any integer from 1 upwards. The metal lines and via connections are embedded in layers 7,11 of dielectric material, for example silicon oxide (SiO₂). The interconnect vias and the conductor lines may be formed of copper or other suitable metals, produced by standard single or double damascene techniques.

The MIMcap comprises a bottom plate 10 of about 50 nm in thickness, which may for example be formed of TaN. On the bottom plate 10 a thick dielectric layer 11 is present. The layer is shown as a single layer, but it may consist of several sublayers, for example one or more thin layers with a specific function such as etch stop layers at the bottom, followed by a thick layer of silicon oxide, and again followed by a thin etch stop or other functional layer or layers. The total thickness of layer 11 is higher than is usually the case for a typical BEOL level and may be between one and two micrometres. A patterned cavity 12 is formed through the complete thickness of the dielectric layer 11. As shown in the drawing, the cavity's circumference lies within the boundary of the TaN bottom plate 10. The cavity 12 is patterned in the sense that it does not have a flat bottom surface. Instead, dielectric pillars 13 are distributed in a regular array on the bottom plate 10. The pillars may for example have a diameter of about 200nm. The cavity 12 is obtained by a high aspect ratio lithography and etch process that removes the material of the dielectric layer 11 in the surface area of the cavity 12, except in the separate locations of the pillars 13. The cavity 12 has a rectangular circumference in the example shown, but this shape is preferably different in practical applications, for example more closely adjacent to and following the outer shape of the pillars 13. The array of pillars is preferably also different, with every other row being shifted with respect to the adjacent rows, so that the mutual distances between neighbouring pillars is the same across the array. Also, the number of pillars 13 is preferably considerably higher than shown in the drawing. These latter considerations are also valid for the configurations according to the invention, described further in this text.

A MIM stack 14/15/16 is formed conformally, i.e. following the topography defined by the bottom and sidewalls of the cavity 12 and the sidewalls of the pillars 13. The MIM stack comprises two electrically conductive layers 14 and 16 with a dielectric layer 15 sandwiched between the two conductive layers. The stack may consist for example of TiN (40 nm)/HfAlOx (10-20 nm)/TiN (20 nm). The notation HfAlOx is not a scientific formula but an abbreviation of the dielectric material hafnium aluminium oxide. The bottom layer 14 is in direct contact with the bottom plate 10. A continuous metal layer 17 fills the remaining volume of the cavity 12. During the production process, this metal layer 17 is formed in said remaining volume and further covers the portions of the MIM layers which envelop the top of the pillars. Said portions of the MIM layers and the metal 17 are then removed from the upper surface of the pillars 13 by a planarization process such as CMP (chemical mechanical polishing), creating a top surface of the pillars that is coplanar with the continuous layer 17. This enables the contacting of the continuous layer 17 by a via connection 5 of the Mₙ₊₁ level. An additional via connection 4 is formed for contacting the conductor lines 1 of the level Mₙ which are in direct contact with the bottom plate 10 of the MIMcap. Conductor lines 2 and 3 of the level Mₙ₊₁ respectively contact the via connections 4 and 5. A possible layout of the conductor lines 1, the via connections 4 and 5 and the conductor lines 2 and 3 is shown in the top view in Figure 1b, but this layout is merely exemplary and other schemes are possible. Figure 1c illustrates the equivalent electrical circuit of the MIMcap, coupled between terminals 2 and 3 which represent the conductor lines with the same reference numerals 2 and 3 in Figures 1a and 1b.

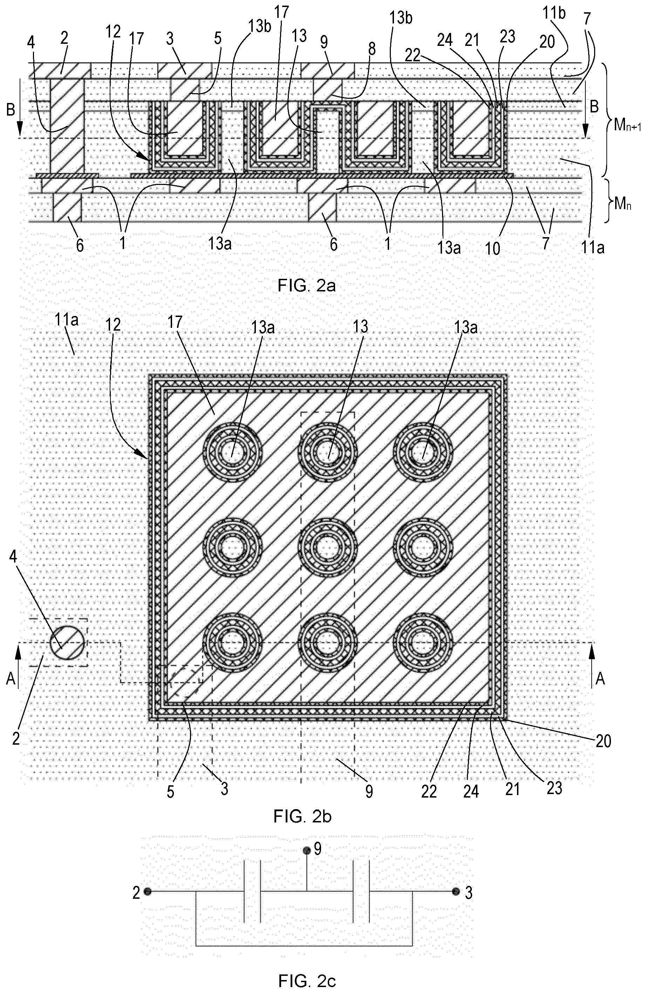

Figures 2a and 2b illustrate a configuration in accordance with a first embodiment of the invention. The configuration is distinct from the prior art MIMcap of Figures 1a and 1b in that it comprises a double MIM stack (i.e. MIMIM). The configuration enables the realization of two MIMcaps coupled in parallel, by providing a contact to the middle conductive layer of the stack.

As seen in Figures 2a and 2b, many elements of the prior art configuration are maintained, and these elements are numbered by the same reference numerals as before : the conductors 1,2,3 and via connections 4,5,6 of the levels Mₙ and Mₙ₊₁, the TaN bottom plate 10, the cavity 12 and the dielectric pillars 13. The conductors 1 are not shown in the section view of Figure 2b, but these conductors may be patterned in the same way as shown in Figure 1b.

It is seen however that the three central pillars are lower in height than the outer pillars, and that these outer pillars comprise a base portion 13a and a top portion 13b. Also, the thick dielectric layer 11 now consists of a base portion 11a and a top portion 11b. As will be seen later in the description of the production process for this configuration, the top portions 11b and 13b are part of the same layer formed of a dielectric material that can be removed by etching the layer selectively with respect to the material of the upper surface of layer 11a. The central pillars 13 do not include said top portion 13b and are therefore lower in height. The MIMIM stack comprises a bottom conductive layer 20, an intermediate conductive layer 21 and a top conductive layer 22, with dielectric layers 23 and 24 separating adjacent conductive layers from each other. A continuous metal layer 17 again fills the remaining volume of the cavity. This metal layer is again planarized but now its upper surface is coplanar only with the outer (higher) pillars of the array. The height difference between the central (lower) pillars and these outer pillars is such that the intermediate layer 21 of the MIMIM stack and its underlying layers 23 (dielectric) and 20 (bottom conductive layer) follow the topography of the top surface of lower-height pillars, so that the intermediate conductive layer 21 is now coplanar with the continuous metal layer 17 and with the upper surface of the higher pillars. The intermediate conductive layer 21 of the MIMIM stack thereby becomes available for contacting said layer by one or more via connections 8 and a conductor line 9 of the Mₙ₊₁ level. This enables coupling the MIMIM stack as two MIMcaps in parallel by connecting the lines 2 and 3, as illustrated in Figure 2c, thereby doubling the capacitance of the overall configuration.

In the wording of the appended claims, the MIMIM stack forms an assembly of capacitors, each capacitor comprising two electrodes and a dielectric, formed by two adjacent conductive layers 20,21 and 21,22 of the stack and their separating dielectric layer 23,24, wherein the bottom electrode 20 of the capacitor assembly, the top electrode 22 of the capacitor assembly and the intermediate electrode 21 can be contacted through via connections 4,5,8 of the second level (Mₙ₊₁) of the interconnect structure.

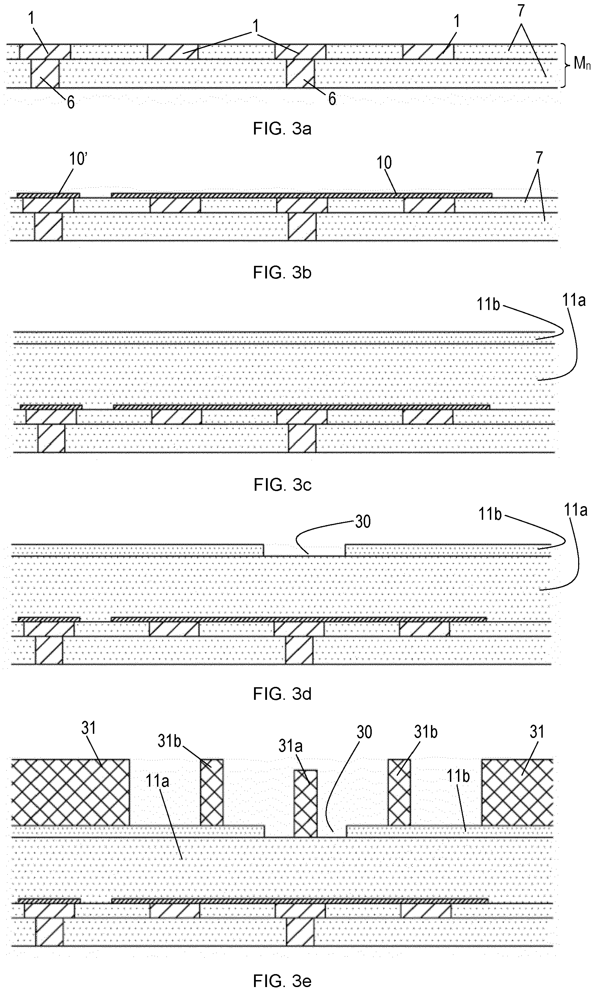

The method for producing the double MIMcap structure of Figure 2 is illustrated in Figures 3a to 3i. The method may be applied on a Si process wafer on which a number of integrated circuit chips or other components are produced simultaneously. Figure 3a shows a small portion of one particular integrated circuit produced on the wafer, at an intermediate stage of the BEOL production process. The image shows a small section of the level Mₙ of the chip's BEOL portion, after the completion of the level by standard damascene techniques. Underneath the structure of Figure 3a and not shown in the drawing are the Si process wafer with active devices (the front end of line portion) produced thereon, and with the BEOL levels M₁ to Mₙ extending above the FEOL.

On the planarized surface of the Mₙ level, the bottom plate 10 is produced by depositing and patterning a layer of TaN of about 50 nm thick, as illustrated in Figure 3b. A layer of TaN 10' is maintained on all the Cu conductors 1 of the Mn level, in order to avoid contamination of the Cu by the etch process used for patterning the TaN. Deposition, e.g. by PVD (physical vapour deposition) and patterning techniques for TaN as well as other suitable materials are known as such and therefore not described here in detail. Then the dielectric layer 11a is produced (see Figure 3c) by standard deposition techniques such as CVD (chemical vapour deposition). Layer 11a may comprise several sublayers deposited consecutively, for example starting with one or more thin functional layers, for example etch stop layers, such as SiCN or SiCO layers of a few tens of nanometres thick, followed by a thick (1 micrometre or more) layer of SiO₂. On the SiO₂ layer a further thin functional layer, for example a SiCN layer of a few tens of nanometres thick could be formed. The total thickness of layer 11 could be in the order of 1 to 2 micrometres.

Then an additional dielectric layer 11b is deposited on layer 11a, as also illustrated in Figure 3c. The thickness of this layer 11b must be controlled accurately and stands in relation to the thickness of the layers of the MIMIM stack, as will be explained later. Layer 11b is a layer that can be removed selectively with respect to layer 11a, in the sense that the surface material of layer 11a forms an etch stop surface when etching layer 11b by a suitable etch recipe. As seen in Figure 3d, layer 11b is patterned by standard lithography and etching, wherein the material of layer 11b is removed in one or more areas 30. In the method for producing the particular embodiment of Figures 2a and 2b, three areas 30 are produced in this way, at the locations where the respective three central pillars 13 of the pillar array are to be created. The surface of the areas 30 is larger than the cross section of the eventual pillars. The etch selectivity enables the removal of layer 11b without any substantial thinning of layer 11a. In one exemplary configuration, layer 11a comprises a layer of SiCN as its top layer, and layer 11b is a layer of SiO₂. SiO₂ can be etched selectively with respect to SiCN with a high degree of etch selectivity.

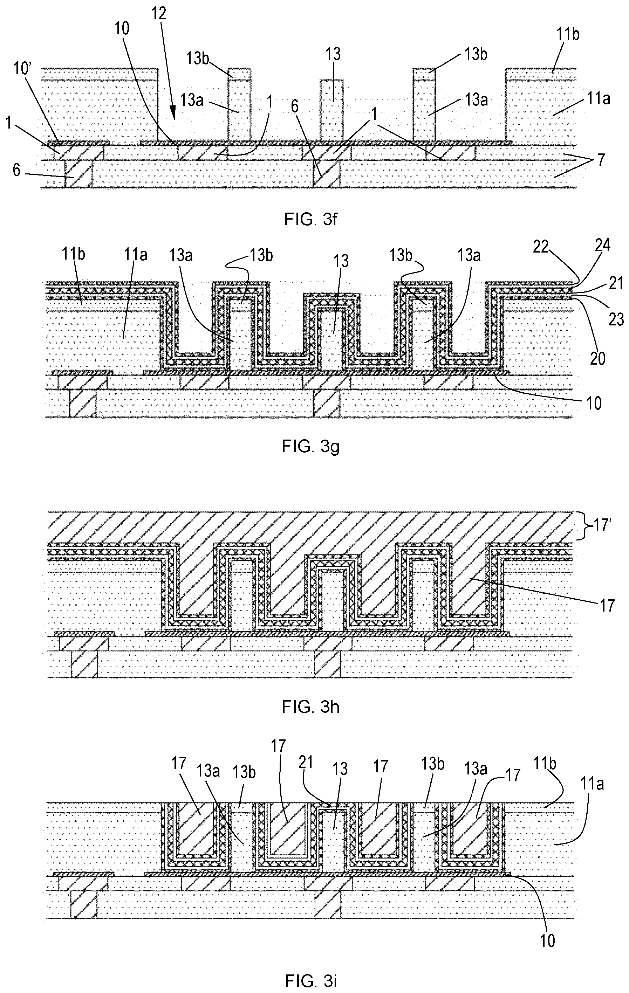

The stack of layers 11a and 11b is then patterned to form the cavity 12. This may be done using known lithography and etching techniques, for example by producing a multilayer patterned hardmask structure 31 (for example formed of amorphous carbon, on top of the dielectric layer 11a+11b, the hardmask 31 covering the areas of the pillars and the area surrounding the cavity location, as illustrated in Figure 3e. It is seen that the hardmask comprises pillar portions 31a placed centrally in the areas 30, i.e. on the exposed surface of layer 11a and other pillar portions 31b placed on the layer 11b. The etch process may include a sequence of consecutively applied etch recipes for removing each sublayer of the dielectric layer 11a+11b, until the cavity 12 is formed, with the bottom plate 10 exposed at the bottom of the cavity. After removing the hardmask 31, the pillars remain at the bottom of the cavity 12, as illustrated in Figure 3f. As a consequence of the prior local removal of the layer 11b, the central pillars 13 are lower in height than the outer pillars, which comprise a base portion 13a and a top portion 13b, the latter being the remaining portion of layer 11b. The height difference is therefore essentially equal to the original thickness of layer 11b.

Then the MIMIM stack 20/23/21/24/22 is deposited by deposition methods known as such, see Figure 3g. The stack may comprise the same materials used in the single MIM stack. However, other materials may be used and the intermediate conductive layer 21 is preferably thicker than the outer layers 20 and 22, as illustrated. Also, one or more conductive layers could consist of several sublayers. The sequence of layers of the MIMIM stack could for example be the following, from bottom to top : 20nm TiN/10nm HfAlOx/ 10nm TiN/ 40nm W/10nm TiN/ 10nm HfAlOx/10nm TiN, i.e. the intermediate conductive layer 21 is itself a stack of TiN, Wand another TiN layer. The MIMIM stack is deposited conformally on the topography defined by the cavity 12 and the pillars 13 (including the lower pillars 13 and the higher pillars 13a+13b), i.e. the stack follows said topography and becomes wrapped around the sidewalls and upper surfaces of the pillars. The spacing between the pillars 13 mutually and between the pillars 13 and the sidewall of the cavity 12 is however designed with respect to the total thickness of the MIMIM stack, in such a way that a considerable open volume is left in the cavity after the MIMIM stack deposition. As illustrated in Figure 3h, this open volume is now filled with an electrically conductive material 17, for example copper, which may be produced by electroplating. This may be preceded by the deposition of a barrier layer and a seed layer as known in the art (not shown). The Cu fills the remaining volume of the cavity 12 and thereafter gets deposited as a horizontal layer 17' on the entire upper surface of the wafer.

A planarization process is now performed and results in the image shown in Figure 3i. The process may comprise several material removal steps such as grinding steps, and CMP steps according to suitable CMP recipes, in order to remove the Cu layer 17', and additionally remove the MIMIM layers from the upper surface of layer 11b. The planarization stops when the upper surface of the layer 11b becomes exposed, possibly removing also a small fraction of this layer at the end of the process. By the careful control of the thickness of this layer 11b with respect to the combined thickness of layers 20, 23 and 21 of the MIMIM stack, the planarization results in the coplanarity of the higher pillars 13a+13b, the continuous Cu layer 17 that fills the cavity, and a thinned and planarized portion of intermediate conductive layer 21 of the MIMIM stack, the latter becoming available for contacting in the areas above the lower-height pillars.

For example, when the MIMIM stack is as described above, i.e. 20nm TiN/10nm HfAlOx/ 10nm TiN/ 40nm W/10nm TiN/ 10nm HfAlOx/10nm TiN, the combined thickness of layers 20, 23 and 21 is 90nm, with layer 21 being 60 nm thick. Therefore, in order to know that when the CMP stops on the surface of layer 11b, about one half of layer 21 has been removed, so that the remaining part becomes available for contacting, layer 11b must be about 60 nm thick (combined thickness of layer 20, 23 and one half of layer 21). A safety range could be applied, for example of 50-70nm. It is clear therefore that a careful control of the various thicknesses and process steps is required in order to obtain the desired result. Tuning and control of these thicknesses and process steps is however within the knowledge of the skilled person.

By additional damascene-type process steps, the via connections 4 and 5 and the conductor lines 2 and 3 of level Mₙ₊₁ are then produced, resulting in the configuration shown in Figures 2a and 2b.

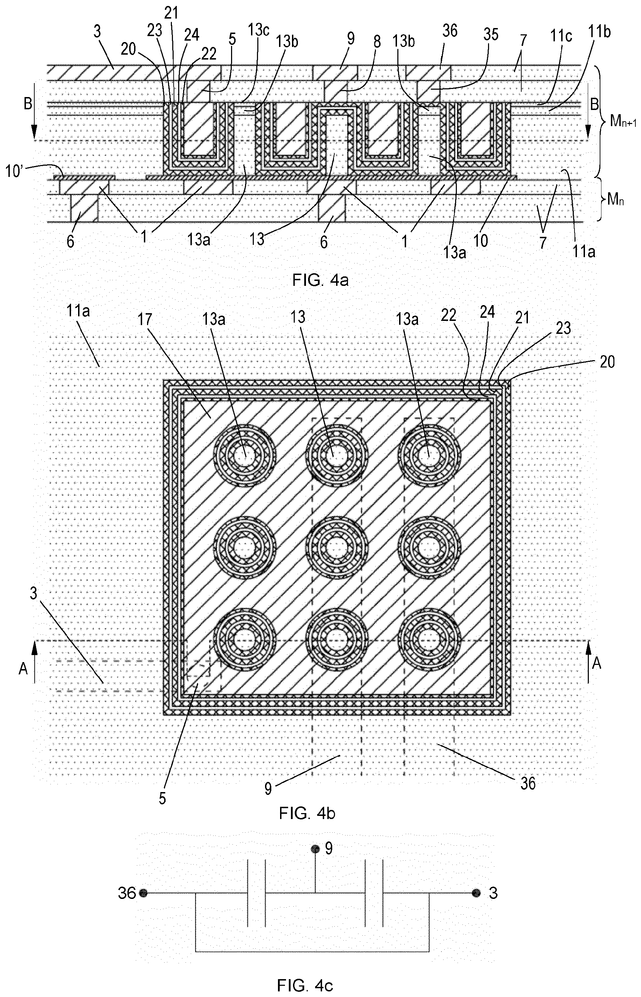

Another embodiment is illustrated in Figures 4a to 4c. The elements appearing in the previous embodiment have been numbered by the same reference numerals. The conductors 1 in level Mₙ may again be patterned in the same way as shown in Figures 1b and 2b. The difference with the embodiment of Figures 2a and 2b is that the deep via connection 4 to the bottom plate 10 is no longer required. Instead, the bottom plate 10 is contacted by a shorter via connection 35 and a contact line 36 in the Mₙ₊₁ level. This is realized by further subdividing the pillar heights. The pillars of the left-hand side row of pillars consist of portions 13a, 13b and 13c. The middle row consists only of the base portion 13a, while the right-hand side pillars consist of portions 13a and 13b. The dielectric layer 11 now consists of portions 11a, 11b and 11c. The height difference 13c is configured so that the bottom conductive layer 20 of the MIMIM stack is wrapped around the upper surface of the 'middle-height' pillars (13a+13b), so that this bottom layer 20 becomes available for contacting it by a short via connection 35 and a metal line 36. The intermediate conductive layer 21 of the MIMIM stack is again available for contacting in areas above the 'lowest' pillars in the centre row, as in the previous embodiment. A possible layout of the conductor lines 2, 3 and 36 is illustrated in Figure 2b, enabling the realization of the parallel capacitor circuit illustrated in Figure 4c.

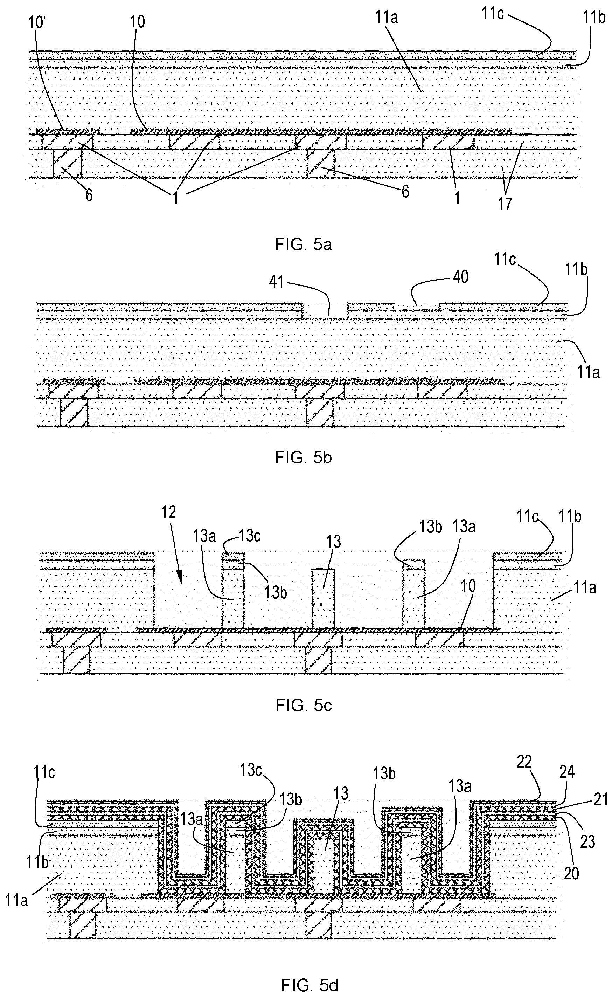

The method for producing this embodiment is illustrated in Figures 5a to 5e. Up to and including the deposition of layer 11b, the steps are the same as for the previous embodiment. As seen in Figure 5a, an additional dielectric layer 11c is deposited on layer 11b. Layer 11c is formed of a material that can be etched selectively with respect to the surface material of layer 11b. Two patterning steps are then performed, as illustrated in Figure 5b, creating openings 40 through the top layer 11c, and 41 through both layers 11b and 11c. The openings are produced using etch recipes which exhibit etch selectivity in the sense that the etch process essentially removes no material from the underlying layers once the bottom of the openings is reached.

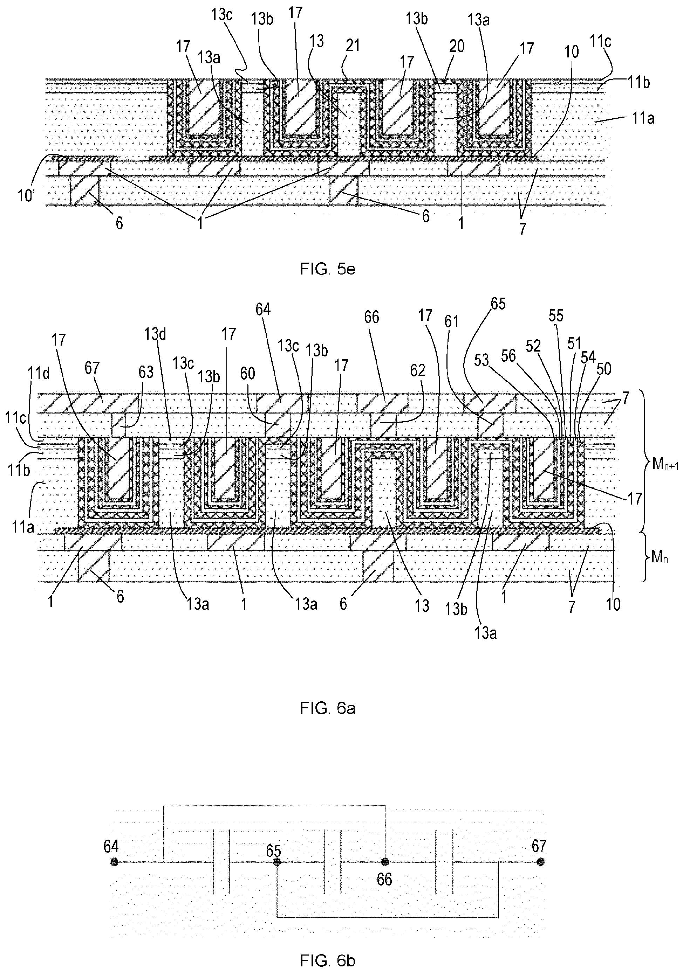

After producing the hardmask for defining the cavity and the array of pillars, the cavity 12 and the pillars are produced, as illustrated in Figure 5c. Three sets of pillars are obtained, each having a different height. Then the MIMIM stack is deposited, see Figure 5d, followed by the deposition and planarization of the Cu layer 17, see Figure 5e. By carefully tuning the thicknesses of layers 11b and 11c with respect to the layers of the MIMIM stack, the planarization results in the availability of both the bottom conductive layer 20 and the middle conductive layer 21 for contacting by via connections of the Mₙ₊₁ level, as shown in Figures 4a and 4b.

The embodiment of Figures 4 and 5 is advantageous in that it does not require etching a deep opening through the thick layer 11 for producing the via connection 4 to the bottom plate 10. This embodiment can be further expanded to realize a circuit comprising more than two capacitors. This can be done by creating additional pillar heights, by depositing additional layers 11d, 11e etc, with suitable etch selectivities of each layer relative to the layer beneath it. An embodiment including 3 MIMcaps is illustrated in Figure 6a. The dielectric layer 11 now comprises sublayers 11a, 11b, 11c and 11d, wherein layers 11b,11c and 11d are removable selectively with respect to their respective underlying layers. In analogy with Figure 5b, openings of 3 different depths are now created through respective layers 11d, 11c+11d and 11b+11c+11d, followed by the formation of the hardmask and the etching of the cavity 12 comprising pillars of 4 different heights : 13, 13a+13b, 13a+13b+13c and 13a+13b+13c+13d. The addition of layer 11d thereby enables the addition of a third MIMcap to the stack, as illustrated in the resulting structure shown in Figure 6a, and comprising a threefold (MI-MI-MI-M) stack consisting of electrically conductive layers 50, 51, 52 and 53, separated by dielectric layers 54, 55 and 56. The conductive layers 50 to 53 are contacted by via connections 60 to 63 and conductor lines 64 to 67. A possible circuit enabled by this configuration is illustrated in Figure 6b.

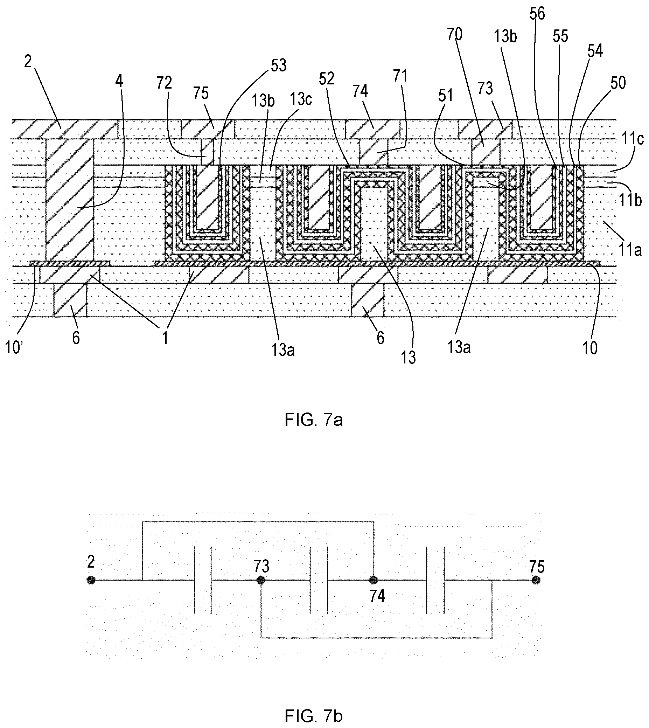

The embodiment of Figures 2 and 3 (with the deep via connection 4) can also be expanded to more than two capacitors, requiring one less additional dielectric layer 11b, 11c for the same number of capacitors, compared to the embodiments of Figures 4 and 5. This is illustrated for the case of the MIMIMIM stack 50/54/51/55/52/56/53 (3 capacitors) in Figures 7a and 7b. Only layers 11b and 11c are required on top of layer 11a, for contacting the second and third conductive layers 51 and 52 through via connections 70 and 71 and metal lines 73 and 74. The top conductive layer 53 is contacted through via connection 72 and metal line 75. The bottom conductive layer 50 is contacted through the via connection 4 and metal line 2, as in the embodiment of Figure 2. The circuit of Figure 6b can also be realized with this configuration, as illustrated in Figure 7b.

While the invention has been illustrated and described in detail in the drawings and foregoing description, such illustration and description are to be considered illustrative or exemplary and not restrictive.

## Claims

1. A semiconductor component comprising a multilayer interconnect structure, said structure comprising multiple levels of electrical conductor lines (1,2,3,9,36,64-67,73-75) and via connections (4,5,8,35,60-63,70-72) embedded in layers (7,11) of dielectric material, the interconnect structure comprising :
- an electrically conductive bottom plate (10), on and in electrically conductive contact with one or more conductor lines (1) of a first level (Mₙ) of the interconnect structure,
- a dielectric layer (11) that is part of a second level (Mₙ₊₁) of the interconnect structure lying directly above the first level, wherein said dielectric layer (11):
o is lying directly on the bottom plate (10),
o comprises a cavity (12) through its full thickness and lying within the boundaries of the bottom plate (10),
- a plurality of pillars (13) of dielectric material distributed on the bottom plate (10),
**characterized in that** the interconnect structure further comprises :
- a stack of layers comprising at least three electrically conductive layers, including a bottom layer (20,50), a top layer (22,53) and at least one intermediate layer (21,51,52), wherein the stack further comprises dielectric layers (23,24,54-56) which separate the conductive layers from each other, and wherein the layers of the stack follow the topography defined by the bottom plate (10), the sidewalls of the pillars (13) and the sidewalls of the cavity (12),
- a continuous layer (17) of electrically conductive material that fills the remaining volume of the cavity, and that is in direct contact with the top conductive layer (22,53) of the stack, wherein the pillars (13) or several subgroups of pillars have different heights, and wherein the height differences are configured so that :
o each intermediate conductive layer (21,51,52) of the stack and all layers of the stack lying beneath said intermediate layer additionally follow the topography defined by the top surface of one or more pillars,
o in separate areas above said top surfaces of said one or more pillars, the upper surface of each intermediate layer (21,51,52) is coplanar with the upper surface of the continuous conductive layer (17),
- a plurality of via connections (4,5,8,35,60-63,70-72) of the second level (Mₙ₊₁) of the interconnect structure, including :
∘ one or more via connections (5,63,72) which are in direct contact with the upper surface of the continuous conductive layer (17),
∘ one or more via connections (8,61,62,70,71) which are in direct contact with said intermediate conductive layers (21,51,52) of the stack, in said one or more separate areas,
∘ one or more via connections (4,35,60) which are in direct or indirect contact with the bottom conductive layer (20) of the stack,
so that the stack of layers forms an assembly of capacitors, each capacitor comprising two electrodes and a dielectric, formed by two adjacent conductive layers of the stack and their separating dielectric layer, wherein the bottom electrode of the capacitor assembly, the top electrode of the capacitor assembly and each intermediate electrode can be contacted through said plurality of via connections (4,5,8,35,60-63,70-72) of the second level (Mₙ₊₁) of the interconnect structure.

2. The component according to claim 1, comprising one or more pillars whose height is configured so that the bottom conductive layer (20) of the stack follows the topography defined by the upper surface of said pillars, and wherein :
- said bottom conductive layer (20,50) is coplanar with the continuous conductive layer (17) in respective additional separate areas lying above said one or more pillars, and
- one or more via connections (35,60) of the second level (Mₙ₊₁) are in direct contact with said bottom conductive layer (20,50) in said additional areas.

3. The component according to claim 1, wherein the second level (Mₙ₊₁) comprises one or more via connections (4) which are in indirect contact with the bottom conductive layer (20,50) of the stack, and wherein said indirect contact is realized by the following :
- said one or more via connections (4) pass through said dielectric layer (11)
- said one or more via connections (4) are in electrical contact with a conductor line (1) of the first level (Mₙ), and
- said conductor line (1) is in electrical contact with the bottom plate (10).

4. The component according to any one of the preceding claims, wherein said component is a semiconductor chip and wherein the interconnect structure is a BEOL portion formed on the front side of the chip.

5. The component according to any one of the preceding claims, wherein said component is a semiconductor chip and wherein the interconnect structure is a power delivery network formed on the back side of the chip.

6. The component according to any one of the preceding claims, wherein said stack of capacitors comprises at least two capacitors coupled in parallel.

7. A method for producing a stack of capacitors incorporated in an interconnect structure of a semiconductor component, said structure comprising multiple levels of electrical conductor lines (1,2,3,9,36,64-67,73-75) and via connections (4,5,8,35,60-63,70-72) embedded in layers of dielectric material, the method comprising the steps of :
- producing a level Mₙ of the interconnect structure, with n lower than the total number of levels, thereby obtaining a planarized surface comprising conductor lines (1) of level Mₙ embedded in and coplanar with a dielectric layer (7),
- producing on said planarized surface and in direct contact with one or more of said conductor lines (1), an electrically conductive bottom plate (10),
- producing a first dielectric layer (11a) on the bottom plate (10) and on the rest of the planarized surface,
- producing at least one additional dielectric layer (11b,11c) on the first dielectric layer (11a), the additional layer or layers being thin in comparison with the first layer,
- in a region above the bottom plate (10), producing one or more first openings (30,40) in the upper additional layer by locally removing material of said upper layer, without substantially removing any material of the layer lying directly under said upper layer,
- if more than one additional layer is present, producing in said region one or more second openings (41) separate from the first openings, by locally removing material of the upper layer and the layer lying under said upper layer, without substantially removing any material of the next layer,
- if more than two additional layers are present, repeating the previous step until reaching the first dielectric layer (11a),
- by lithography and etching, removing the material of the first and additional dielectric layers (11a-11d) in an area having a circumference that surrounds all the openings (30,40,41), except in predefined portions of said openings, thereby creating a cavity (12) that lies within the outer boundaries of the bottom plate (10), with pillars (13) of dielectric material remaining on the bottom of the cavity, the pillars having different heights in accordance with the number of additional layers produced on the first dielectric layer (11a),
- producing a stack of layers on the topography defined by the cavity (12) and the pillars (13), said stack comprising at least three electrically conductive layers, including a bottom layer (20,50), a top layer (22,53) and at least one intermediate layer (21,51,52), wherein the stack further comprises dielectric layers (23,24,54-56) which separate the conductive layers from each other, and wherein the layers of the stack are conformal layers, i.e. layers which follow the topography defined by the cavity (12) and the pillars (13),
- filling the remaining volume of the cavity (12) with an electrically conductive material, wherein said electrically conductive material (17) is in direct contact with said top conductive layer (22,53),
- planarizing the electrically conductive material (17) and the stack to the level of the top additional dielectric layer (11c,11d) or slightly beyond said level, to thereby create a planarized continuous conductive layer (17), wherein the thicknesses of the one or more additional dielectric layers (11b,11c,11d) are configured in relation to the thicknesses of the layers of the stack, so that each of the intermediate conductive layers of the stack is planarized to the same level as the continuous conductive layer (17), in respective separate areas above a plurality of pillars which are lower than the level of the top additional layer,
- producing interconnect vias of the subsequent level Mₙ₊₁ of the interconnect structure, including :
∘ one or more via connections (5,63,72) which are in direct contact with the upper surface of the continuous conductive layer (17),
∘ one or more via connections (8,61,62,70,71) which are in direct contact with said intermediate conductive layers (21,51,52) of the stack, in said one or more separate areas,
∘ one or more via connections (4,35,60) which are in direct or indirect contact with the bottom conductive layer (20,50) of the stack.

## Patentansprüche

1. Halbleiterkomponente, die eine mehrschichtige Verbindungsstruktur umfasst, wobei die Struktur mehrere Ebenen elektrischer Leiterbahnen (1, 2, 3, 9, 36, 64-67, 73-75) und Durchkontaktierungsverbindungen (4, 5, 8, 35, 60-63, 70-72) umfasst, die in Schichten (7, 11) aus dielektrischem Material eingebettet sind, wobei die Verbindungsstruktur umfasst:
- eine elektrisch leitfähige untere Platte (10), auf und in elektrisch leitfähigem Kontakt mit einer oder mehreren Leiterbahnen (1) einer ersten Ebene (Mₙ) der Verbindungsstruktur,
- eine dielektrische Schicht (11), die Teil einer zweiten Ebene (Mₙ₊₁₎ der Verbindungsstruktur ist, die direkt über der ersten Ebene liegt, wobei die dielektrische Schicht (11):
- direkt auf der unteren Platte (10) liegt,
- einen Hohlraum (12) durch ihre gesamte Dicke und innerhalb der Grenzen der unteren Platte (10) liegend umfasst,
- eine Vielzahl von Säulen (13) aus dielektrischem Material, die auf der unteren Platte (10) verteilt sind,
**dadurch gekennzeichnet, dass** die Verbindungsstruktur weiter umfasst:
- einen Schichtstapel, der mindestens drei elektrisch leitfähige Schichten umfasst, die eine untere Schicht (20, 50), eine obere Schicht (22, 53) und mindestens eine Zwischenschicht (21, 51, 52) beinhalten, wobei der Stapel weiter dielektrische Schichten (23, 24, 54-56) umfasst, die die leitfähigen Schichten voneinander trennen, und wobei die Schichten des Stapels der Topographie folgen, die durch die untere Platte (10), die Seitenwände der Säulen (13) und die Seitenwände des Hohlraums (12) definiert ist,
- eine durchgehende Schicht (17) aus elektrisch leitfähigem Material, die das verbleibende Volumen des Hohlraums füllt und die mit der oberen leitfähigen Schicht (22, 53) des Stapels in direktem Kontakt steht, wobei die Säulen (13) oder mehrere Teilgruppen von Säulen unterschiedliche Höhen aufweisen und wobei die Höhenunterschiede so konfiguriert sind, dass:
- jede leitfähige Zwischenschicht (21, 51, 52) des Stapels und alle Schichten des Stapels, die unter der Zwischenschicht liegen, zusätzlich der Topographie folgen, die durch die obere Fläche einer oder mehrerer Säulen definiert ist,
- in getrennten Bereichen über den oberen Flächen der einen oder der mehreren Säulen die obere Fläche jeder Zwischenschicht (21, 51, 52) mit der oberen Fläche der durchgehenden leitfähigen Schicht (17) komplanar ist,
- eine Vielzahl von Durchkontaktierungsverbindungen (4, 5, 8, 35, 60-63, 70-72) der zweiten Ebene (Mₙ₊₁) der Verbindungsstruktur, welche beinhalten:
- eine oder mehrere Durchkontaktierungsverbindungen (5, 63, 72), die mit der oberen Fläche der durchgehenden leitfähigen Schicht (17) in direktem Kontakt stehen,
- eine oder mehrere Durchkontaktierungsverbindungen (8, 61, 62, 70, 71), die mit den leitfähigen Zwischenschichten (21, 51, 52) des Stapels in direktem Kontakt stehen, in dem einen oder den mehreren separaten Bereichen,
- eine oder mehrere Durchkontaktierungsverbindungen (4, 35, 60), die mit der unteren leitfähigen Schicht (20) des Stapels in direktem oder indirektem Kontakt stehen,
sodass der Schichtstapel eine Anordnung von Kondensatoren bildet, wobei jeder Kondensator zwei Elektroden und ein Dielektrikum umfasst, die von zwei benachbarten leitfähigen Schichten des Stapels und ihrer trennenden dielektrischen Schicht gebildet werden, wobei die untere Elektrode der Kondensatoranordnung, die obere Elektrode der Kondensatoranordnung und jede Zwischenelektrode durch die Vielzahl von Durchkontaktierungsverbindungen (4, 5, 8, 35, 60-63, 70-72) der zweiten Ebene (Mₙ₊₁) der Verbindungsstruktur kontaktiert werden können.

2. Komponente nach Anspruch 1, die eine oder mehrere Säulen umfasst, deren Höhe so konfiguriert ist, dass die untere leitfähige Schicht (20) des Stapels der Topographie folgt, die durch die obere Fläche der Säulen definiert ist, und wobei:
- die untere leitfähige Schicht (20, 50) mit der durchgehenden leitfähigen Schicht (17) in jeweiligen zusätzlichen getrennten Bereichen, die über der einen oder den mehreren Säulen liegen, komplanar ist, und
- eine oder mehrere Durchkontaktierungsverbindungen (35, 60) der zweiten Ebene (Mₙ₊₁) in den zusätzlichen Bereichen mit der unteren leitfähigen Schicht (20, 50) in direktem Kontakt stehen.

3. Komponente nach Anspruch 1, wobei die zweite Ebene (Mₙ₊₁) eine oder mehrere Durchkontaktierungsverbindungen (4) umfasst, die mit der unteren leitfähigen Schicht (20, 50) des Stapels in indirektem Kontakt stehen, und wobei der indirekte Kontakt dadurch hergestellt wird, dass:
- die eine oder die mehreren Durchkontaktierungsverbindungen (4) durch die dielektrische Schicht (11) verlaufen,
- die eine oder die mehreren Durchkontaktierungsverbindungen (4) mit einer Leiterbahn (1) der ersten Ebene (Mₙ) in elektrischem Kontakt stehen, und
- die Leiterbahn (1) mit der unteren Platte (10) in elektrischem Kontakt steht.

4. Komponente nach einem der vorstehenden Ansprüche, wobei die Komponente ein Halbleiterchip ist und wobei die Verbindungsstruktur ein BEOL-Abschnitt ist, der auf der Vorderseite des Chips gebildet ist.

5. Komponente nach einem der vorstehenden Ansprüche, wobei die Komponente ein Halbleiterchip ist und wobei die Verbindungsstruktur ein Stromversorgungsnetzwerk ist, das auf der Rückseite des Chips gebildet ist.

6. Komponente nach einem der vorstehenden Ansprüche, wobei der Kondensatorstapel mindestens zwei parallel geschaltete Kondensatoren umfasst.

7. Verfahren zum Erzeugen eines Stapels von Kondensatoren, die in eine Verbindungsstruktur einer Halbleiterkomponente integriert sind, wobei die Struktur mehrere Ebenen elektrischer Leiterbahnen (1, 2, 3, 9, 36, 64-67, 73-75) und Durchkontaktierungsverbindungen (4, 5, 8, 35, 60-63, 70-72) umfasst, die in Schichten aus dielektrischem Material eingebettet sind, wobei das Verfahren die folgenden Schritte umfasst:
- Erzeugen einer Ebene Mₙ der Verbindungsstruktur, wobei n kleiner ist als die Gesamtzahl an Ebenen, wodurch eine planarisierte Fläche erhalten wird, die Leiterbahnen (1) von Ebene Mₙ umfasst, die in eine dielektrische Schicht (7) eingebettet und mit dieser komplanar sind,
- Erzeugen einer elektrisch leitfähigen unteren Platte (10) auf der planarisierten Fläche und in direktem Kontakt mit einer oder mehreren der Leiterbahnen (1),
- Erzeugen einer ersten dielektrischen Schicht (11a) auf der unteren Platte (10) und auf dem Rest der planarisierten Fläche,
- Erzeugen mindestens einer zusätzlichen dielektrischen Schicht (11b, 11c) auf der ersten dielektrischen Schicht (11a), wobei die zusätzlich(e) Schicht oder Schichten im Vergleich zur ersten Schicht dünn ist/sind,
- Erzeugen, in einem Bereich über der unteren Platte (10), einer oder mehrerer erster Öffnungen (30, 40) in der oberen zusätzlichen Schicht durch lokales Entfernen von Material der oberen Schicht, ohne im Wesentlichen Material der Schicht, die direkt unter der oberen Schicht liegt, zu entfernen,
- wenn mehr als eine zusätzliche Schicht vorhanden ist, Erzeugen einer oder mehrerer zweiter Öffnungen (41) von den ersten Öffnungen getrennt in dem Bereich durch lokales Entfernen von Material der oberen Schicht und der Schicht, die unter der oberen Schicht liegt, ohne im Wesentlichen Material der nächsten Schicht zu entfernen,
- wenn mehr als zwei zusätzliche Schichten vorhanden sind, Wiederholen des vorherigen Schrittes, bis die erste dielektrische Schicht (11a) erreicht wird,
- Entfernen, durch Lithographie und Ätzen, des Materials der ersten und der zusätzlichen dielektrischen Schichten (11a-11d) in einem Bereich, der einen Umfang aufweist, der alle der Öffnungen (30, 40, 41), außer in vordefinierten Abschnitten der Öffnungen, umgibt, wodurch ein Hohlraum (12) geschaffen wird, der innerhalb der äußeren Grenzen der unteren Platte (10) liegt, wobei Säulen (13) aus dielektrischem Material auf der Unterseite des Hohlraums verbleiben, wobei die Säulen in Übereinstimmung mit der Anzahl an zusätzlichen Schichten, die auf der ersten dielektrischen Schicht (11a) erzeugt wurden, unterschiedliche Höhen aufweisen,
- Erzeugen eines Schichtstapels auf der Topographie, die durch den Hohlraum (12) und die Säulen (13) definiert ist, wobei der Stapel mindestens drei elektrisch leitfähige Schichten umfasst, die eine untere Schicht (20, 50), eine obere Schicht (22, 53) und mindestens eine Zwischenschicht (21, 51, 52) beinhalten, wobei der Stapel weiter dielektrische Schichten (23, 24, 54-56) umfasst, die die leitfähigen Schichten voneinander trennen, und wobei die Schichten des Stapels konforme Schichten sind, d. h. Schichten, die der Topographie folgen, die durch den Hohlraum (12) und die Säulen (13) definiert ist,
- Füllen des verbleibenden Volumens des Hohlraums (12) mit einem elektrisch leitfähigen Material, wobei das elektrisch leitfähige Material (17) mit der oberen leitfähigen Schicht (22, 53) in direktem Kontakt steht,
- Planarisieren des elektrisch leitfähigen Materials (17) und des Stapels auf die Ebene der oberen zusätzlichen dielektrischen Schicht (11c, 11d) oder geringfügig jenseits der Ebene, um dadurch eine planarisierte, durchgehende leitfähige Schicht (17) zu schaffen, wobei die Dicken der einen oder der mehreren zusätzlichen dielektrischen Schichten (11b, 11c, 11d) im Verhältnis zu den Dicken der Schichten des Stapels so konfiguriert sind, dass jede der leitfähigen Zwischenschichten des Stapels auf die gleiche Ebene wie die durchgehende leitfähige Schicht (17) planarisiert ist, in jeweiligen getrennten Bereichen über einer Vielzahl von Säulen, die niedriger sind als die Ebene der oberen zusätzlichen Schicht,
- Erzeugen von Verbindungsdurchkontaktierungen der nachfolgenden Ebene Mₙ₊₁ der Verbindungsstruktur, welche beinhalten:
- eine oder mehrere Durchkontaktierungsverbindungen (5, 63, 72), die mit der oberen Fläche der durchgehenden leitfähigen Schicht (17) in direktem Kontakt stehen,
- eine oder mehrere Durchkontaktierungsverbindungen (8, 61, 62, 70, 71), die mit den leitfähigen Zwischenschichten (21, 51, 52) des Stapels in direktem Kontakt stehen, in dem einen oder den mehreren separaten Bereichen,
- eine oder mehrere Durchkontaktierungsverbindungen (4, 35, 60), die mit der unteren leitfähigen Schicht (20, 50) des Stapels in direktem oder indirektem Kontakt stehen.

## Revendications

1. Composant semi-conducteur comprenant une structure d'interconnexion multicouche, ladite structure comprenant de multiples niveaux de lignes conductrices électriques (1, 2, 3, 9, 36, 64-67, 73-75) et de connexions via (4, 5, 8, 35, 60-63, 70-72) intégrées dans des couches (7, 11) de matériau diélectrique, la structure d'interconnexion comprenant :
- une plaque inférieure électriquement conductrice (10), sur et en contact électriquement conducteur avec une ou plusieurs lignes conductrices (1) d'un premier niveau (Mₙ) de la structure d'interconnexion,
- une couche diélectrique (11) qui fait partie d'un second niveau (Mₙ₊₁) de la structure d'interconnexion située directement au-dessus du premier niveau, dans lequel ladite couche diélectrique (11) :
repose directement sur la plaque inférieure (10),
comprend une cavité (12) sur toute son épaisseur et située dans les limites de la plaque inférieure (10),
- une pluralité de piliers (13) de matériau diélectrique répartis sur la plaque inférieure (10),
**caractérisé en ce que** la structure d'interconnexion comprend en outre :
- un empilement de couches comprenant au moins trois couches électriquement conductrices, incluant une couche inférieure (20, 50), une couche supérieure (22, 53) et au moins une couche intermédiaire (21, 51, 52), dans lequel l'empilement comprend en outre des couches diélectriques (23, 24, 54-56) qui séparent les couches conductrices les unes des autres, et dans lequel les couches de l'empilement suivent la topographie définie par la plaque inférieure (10), les parois latérales des piliers (13) et les parois latérales de la cavité (12),
- une couche continue (17) de matériau électriquement conducteur qui remplit le volume restant de la cavité, et qui est en contact direct avec la couche conductrice supérieure (22, 53) de l'empilement, dans lequel les piliers (13) ou plusieurs sous-groupes de piliers présentent des hauteurs différentes, et dans lequel les différences de hauteur sont configurées de telle sorte que :
chaque couche conductrice intermédiaire (21, 51, 52) de l'empilement et toutes les couches de l'empilement situées sous ladite couche intermédiaire suivent en outre la topographie définie par la surface supérieure d'un ou plusieurs piliers,
dans des zones distinctes au-dessus desdites surfaces supérieures desdits un ou plusieurs piliers, la surface supérieure de chaque couche intermédiaire (21, 51, 52) soit coplanaire avec la surface supérieure de la couche conductrice continue (17),
- une pluralité de connexions via (4, 5, 8, 35, 60-63, 70-72) du second niveau (Mₙ₊₁) de la structure d'interconnexion, incluant :
une ou plusieurs connexions via (5, 63, 72) qui sont en contact direct avec la surface supérieure de la couche conductrice continue (17),
une ou plusieurs connexions via (8, 61, 62, 70, 71) qui sont en contact direct avec lesdites couches conductrices intermédiaires (21, 51, 52) de l'empilement, dans lesdites une ou plusieurs zones distinctes,
une ou plusieurs connexions via (4, 35, 60) qui sont en contact direct ou indirect avec la couche conductrice inférieure (20) de l'empilement,
de sorte que l'empilement de couches forme un ensemble condensateur, chaque condensateur comprenant deux électrodes et un diélectrique, formé par deux couches conductrices adjacentes de l'empilement et leur couche diélectrique de séparation, dans lequel l'électrode inférieure de l'ensemble condensateur, l'électrode supérieure de l'ensemble condensateur et chaque électrode intermédiaire peuvent être mises en contact par l'intermédiaire de ladite pluralité de connexions via (4, 5, 8, 35, 60-63, 70-72) du second niveau (Mₙ₊₁) de la structure d'interconnexion.

2. Composant selon la revendication 1, comprenant un ou plusieurs piliers dont la hauteur est configurée de telle sorte que la couche conductrice inférieure (20) de l'empilement suive la topographie définie par la surface supérieure desdits piliers, et dans lequel :
- ladite couche conductrice inférieure (20, 50) est coplanaire avec la couche conductrice continue (17) dans des zones distinctes supplémentaires respectives situées au-dessus desdits un ou plusieurs piliers, et
- une ou plusieurs connexions via (35, 60) du second niveau (Mₙ₊₁) sont en contact direct avec ladite couche conductrice inférieure (20, 50) dans lesdites zones supplémentaires.

3. Composant selon la revendication 1, dans lequel le second niveau (Mₙ₊₁) comprend une ou plusieurs connexions via (4) qui sont en contact indirect avec la couche conductrice inférieure (20, 50) de l'empilement, et dans lequel ledit contact indirect est réalisé par ce qui suit :
- lesdites une ou plusieurs connexions via (4) traversent ladite couche diélectrique (11),
- lesdites une ou plusieurs connexions via (4) sont en contact électrique avec une ligne conductrice (1) du premier niveau (Mₙ), et
- ladite ligne conductrice (1) est en contact électrique avec la plaque inférieure (10).

4. Composant selon l'une quelconque des revendications précédentes, dans lequel ledit composant est une puce semi-conductrice et dans lequel la structure d'interconnexion est une partie BEOL formée sur la face avant de la puce.

5. Composant selon l'une quelconque des revendications précédentes, dans lequel ledit composant est une puce semi-conductrice et dans lequel la structure d'interconnexion est un réseau de distribution d'énergie formé sur la face arrière de la puce.

6. Composant selon l'une quelconque des revendications précédentes, dans lequel ledit empilement de condensateurs comprend au moins deux condensateurs couplés en parallèle.

7. Procédé de production d'un empilement de condensateurs incorporés dans une structure d'interconnexion d'un composant semi-conducteur, ladite structure comprenant de multiples niveaux de lignes conductrices électriques (1, 2, 3, 9, 36, 64-67, 73-75) et de connexions via (4, 5, 8, 35, 60-63, 70-72) intégrées dans des couches de matériau diélectrique, le procédé comprend les étapes de :
- production d'un niveau Mₙ de la structure d'interconnexion, avec n inférieur au nombre total de niveaux, obtenant ainsi une surface planarisée comprenant des lignes conductrices (1) de niveau Mₙ intégrées dans et coplanaires avec une couche diélectrique (7),
- production, sur ladite surface planarisée et en contact direct avec une ou plusieurs desdites lignes conductrices (1), d'une plaque inférieure électriquement conductrice (10),
- production d'une première couche diélectrique (11a) sur la plaque inférieure (10) et sur le reste de la surface planarisée,
- production d'au moins une couche diélectrique supplémentaire (11b, 11c) sur la première couche diélectrique (11a), la ou les couches supplémentaires étant minces par rapport à la première couche,
- dans une région au-dessus de la plaque inférieure (10), production d'une ou plusieurs premières ouvertures (30, 40) dans la couche supplémentaire supérieure en enlevant localement de la matière de ladite couche supérieure, sans enlever sensiblement de matière de la couche située directement sous ladite couche supérieure,
- si plus d'une couche supplémentaire est présente, production dans ladite région d'une ou plusieurs secondes ouvertures (41) distinctes des premières ouvertures, en enlevant localement de la matière de la couche supérieure et de la couche située sous ladite couche supérieure, sans enlever sensiblement de matière de la couche suivante,
- si plus de deux couches supplémentaires sont présentes, répétition de l'étape précédente jusqu'à atteindre la première couche diélectrique (11a),
- par lithographie et gravure, enlèvement de la matière de la première couche diélectrique et des couches diélectriques supplémentaires (11a-11d) dans une zone présentant une circonférence qui entoure toutes les ouvertures (30, 40, 41), sauf dans des parties prédéfinies desdites ouvertures, créant ainsi une cavité (12) qui se trouve dans les limites extérieures de la plaque inférieure (10), avec des piliers (13) de matériau diélectrique restant sur le fond de la cavité, les piliers présentant des hauteurs différentes en fonction du nombre de couches supplémentaires produites sur la première couche diélectrique (11a),
- production d'un empilement de couches sur la topographie définie par la cavité (12) et les piliers (13), ledit empilement comprenant au moins trois couches électriquement conductrices, incluant une couche inférieure (20, 50), une couche supérieure (22, 53) et au moins une couche intermédiaire (21, 51, 52), dans lequel l'empilement comprend en outre des couches diélectriques (23, 24, 54-56) qui séparent les couches conductrices les unes des autres, et dans lequel les couches de l'empilement sont des couches conformes, c'est-à-dire des couches qui suivent la topographie définie par la cavité (12) et les piliers (13),
- remplissage du volume restant de la cavité (12) avec un matériau électriquement conducteur, dans lequel ledit matériau électriquement conducteur (17) est en contact direct avec ladite couche conductrice supérieure (22, 53),
- planarisation du matériau électriquement conducteur (17) et de l'empilement jusqu'au niveau de la couche diélectrique supplémentaire supérieure (11c, 11d) ou légèrement au-delà dudit niveau, pour ainsi créer une couche conductrice continue planarisée (17), dans lequel les épaisseurs des une ou plusieurs couches diélectriques supplémentaires (11b, 11c, 11d) sont configurées par rapport aux épaisseurs des couches de l'empilement, de sorte que chacune des couches conductrices intermédiaires de l'empilement soit planarisée au même niveau que la couche conductrice continue (17), dans des zones distinctes respectives au-dessus d'une pluralité de piliers qui sont plus bas que le niveau de la couche supplémentaire supérieure,
- production de vias d'interconnexion du niveau suivant Mₙ₊₁ de la structure d'interconnexion, incluant :
une ou plusieurs connexions via (5, 63, 72) qui sont en contact direct avec la surface supérieure de la couche conductrice continue (17),
une ou plusieurs connexions via (8, 61, 62, 70, 71) qui sont en contact direct avec lesdites couches conductrices intermédiaires (21, 51, 52) de l'empilement, dans lesdites une ou plusieurs zones distinctes,
une ou plusieurs connexions via (4, 35, 60) qui sont en contact direct ou indirect avec la couche conductrice inférieure (20, 50) de l'empilement.
